# EUROPEAN PATENT APPLICATION

(11) **EP 1 519 390 A2**
(43) Date of publication of application: **30.03.2005**
(21) Application number: 04255756.1
(22) Date of filing: 22.09.2004
(51) Int. Cl.: H01F 6/04, G01R 33/3815

(54) **Cryogen-free high temperature superconducting magnet with thermal reservoir**

(30) Priority: 24.09.2003 US 671146
(71) Applicant: GENERAL ELECTRIC COMPANY, Schenectady, NY 12345 (US)
(72) Inventor: Ryan, David Thomas, Niskayuna New York 12309 (US); Huang, Xianrui, Clifton Park New York 12065 (US); Laskaris, Evangelos Trifon, Niskayuna New York 12309 (US)
(74) Representative: Pedder, James Cuthbert

(57) **Abstract**

A cryogen free superconducting magnet assembly having a high T_{c} superconducting magnet and a thermal reservoir in thermal contact with the high T_{c} superconducting magnet. A method of cooling a cryogen free superconducting magnet assembly and an MRI system having cryogen free superconducting magnet assemblies.

## Description

This invention relates generally to methods and apparatus for cooling a superconducting magnet, and specifically to cooling a magnet used in a magnetic resonance imaging (MRI) system.

There are various magnetic imaging systems which utilize superconducting magnets. One example of an imaging system is a magnetic resonance imaging (MRI) system. MRI systems are used to image a portion of a patient's body.

Superconducting MRI systems typically utilize one superconducting magnet, often with multiple coils. An imaging volume is provided inside the magnet. A person or material is placed into an imaging volume and an image or signal is detected and then processed by a processor, such as a computer.

The majority of existing superconducting MRI magnets are made of a niobium-titanium material which is cooled to a temperature of 4.2 K with liquid helium. This has the disadvantage of requiring a supply of liquid helium which is expensive and may not be available in underdeveloped countries. Further, in the event of a power failure or a mechanical failure the cooling system, only the latent heat of the helium reserve is available to provide "ride-through" (the period of time from the failure of the cooling mechanism to the loss of superconductivity due to a rise in temperature above the critical temperature of the superconducting material) due to the small heat capacity of the materials in the MRI system.

In accordance with one preferred aspect of the present invention, there is provided a cryogen free superconducting magnet assembly comprising a high T_{c} superconducting magnet and a thermal reservoir in thermal contact with the high T_{c} superconducting magnet, wherein the thermal reservoir comprises a material having a heat capacity of at least about 0.065 J/gK at 25 K.

In accordance with one preferred aspect of the present invention, there is provided a method of cooling a cryogen free superconducting magnet assembly comprising providing a high T_{c} superconducting magnet thermally connected to a thermal reservoir, the thermal reservoir comprising a material having a heat capacity of at least about 0.065 J/gK at 25 K; providing a cryocooler thermally connected to the high T_{c} superconducting magnet, and withdrawing heat from the high T_{c} superconducting magnet without using a cryogen.

In accordance with one preferred aspect of the present invention, there is provided an MRI system comprising a cryogen free superconducting magnet assembly having a high T_{c} superconducting magnet, and a thermal reservoir in thermal contact with the high T_{c} superconducting magnet, the thermal reservoir comprising a material having a heat capacity of at least about 0.065 J/gK at 25 K, wherein an imaging volume is formed inside the superconducting magnet assembly and a cryocooler thermally connected to the thermal reservoir.

In accordance with one preferred aspect of the present invention, there is provided an MRI system comprising a first cryogen free superconducting magnet assembly having a first high T_{c} superconducting magnet, and a first thermal reservoir in thermal contact with the first high T_{c} superconducting magnet, the first thermal reservoir comprising a material having a heat capacity of at least about 0.065 J/gK at 25 K; and a second cryogen free superconducting magnet assembly having a second high T_{c} superconducting magnet, and a second thermal reservoir in thermal contact with the second high T_{c} superconducting magnet, the second thermal reservoir comprising a material having a heat capacity of at least about 0.065 J/gK at 25 K, such that an imaging volume is formed between the first and second assemblies.

In accordance with one preferred aspect of the present invention, there is provided an MRI system comprising a first cryogen free superconducting magnet assembly having a first high T_{c} superconducting magnet; a second cryogen free superconducting magnet assembly having a second high T_{c} superconducting magnet; and a thermal reservoir in thermal contact with the first and second high T_{c} superconducting magnets, the thermal reservoir comprising a material having a heat capacity of at least about 0.065 J/gK at 25 K, such that an imaging volume is formed between the first and second assemblies.

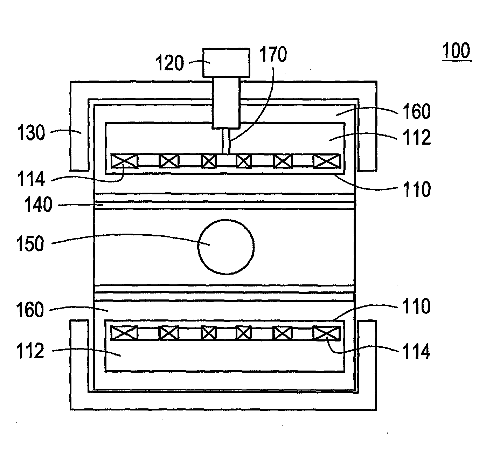

The invention will now be described in greater detail, by way of example, with reference to the drawings, the single figure of which is a schematic illustration of an MRI according to a first preferred embodiment of the present invention.

The present inventors have realized that liquid cryogens can be eliminated from superconducting systems while maintaining ride-through capability when a thermal reservoir made of a high heat capacity material surrounds or is placed in thermal contact with the superconducting magnets cooled with a cryocooler. By using a material with a heat capacity, and a preferably moderate amount of material, enough thermal mass is available to provide adequate ride-through in the event of a power failure. This is particularly advantageous for operation in underdeveloped countries or remote regions where cryogens are often expensive or unavailable.

A cryogen free superconducting magnet assembly according to one preferred embodiment of the invention will now be described. In this embodiment, high T_{c} superconducting coils capable of operating at temperatures above 20 K are in thermal contact with a thermal reservoir fabricated from a material with a high heat capacity. Preferably, high T_{c} superconducting coils are surrounded by the thermal reservoir. Example high T_{c} superconducting materials include, but are not limited to, DBCO (Dysprosium Barium Copper Oxide), YBCO (Yttrium Barium Copper Oxide), BSCCO (Bismuth Strontium Calcium Copper Oxide), and MgB₂ (Magnesium Diboride).

Conventionally, the critical temperature of a superconductor refers to the temperature at which the superconducting material losses superconductivity. However, for the purposes of this specification, the critical temperature is the temperature above which the magnet can no longer operate at its rated magnetic field. The rated magnetic field may be unique to each design and is typically a function of magnet size, shape and operating temperature.

Preferably, the thermal reservoir material has a heat capacity of at least about 0.065 J/gK at 25 K. More preferably, the thermal reservoir material has a heat capacity of at least about 0.10 J/gK at 25 K. Alternatively, the thermal reservoir material may have a minimum enthalpy change of at least about 0.65 J/g between 20 K and 30 K. Preferably, the thermal reservoir material has a minimum enthalpy change of at least about 1.55 J/g between 20 K and 30 K.

The thermal capacity of the thermal reservoir is preferably greater than about 9 x 10⁵ J. The thermal mass of the thermal reservoir to provide this thermal capacity will vary depending on the heat capacity of the thermal reservoir material. However, the thermal mass is typically greater than about 525 kg. Preferably, the thermal reservoir has sufficient thermal mass to provide ride-through of at least 5 hours in the event of loss of power. More preferably, the thermal reservoir has sufficient thermal mass to provide ride-through of at least 10 hours.

Suitable materials for the thermal reservoir of the present embodiment include ice, epoxy, methacrylate, polyurethane, synthetic rubber, natural rubber, plastic, resin, and lead. Preferred materials include ice, Araldite® and Glyptal®. Araldite® is a family of materials which span epoxy, methacrylate, and polyurethane. Glyptal® is a resin based plastic. Heat capacity and enthalpy change data for these materials are summarized in the table below.

| Material | Specific heat (J/g-K) | | | Enthalpy (J/g) | | | ΔH (J/g) | Mass (kg) (10 Hr ride through) |
|---|---|---|---|---|---|---|---|---|
| | 20 K | 25 K | 30 K | 20 K | 25 K | 30 K | 20-30 K | |
| Ice | 0.114 | 0.17 | 0.229 | 0.615 | | 2.33 | 1.715 | 525 |
| Araldite® | 0.081 | | 0.135 | 0.608 | | 1.688 | 1.080 | 833 |
| Lead | 0.05 | 0.068 | 0.079 | 0.368 | 0.672 | 1.042 | 0.674 | 1335 |
| Rubber | 0.113 | 0.155 | 0.196 | 0.77 | 1.44 | 2.32 | 1.55 | 581 |
| Glyptal® | | | | 0.67 | 1.3 | 2.2 | 1.53 | 588 |

The figure illustrates a cross section of a cylindrical MRI system 100 according to a second embodiment of the invention. In the figure, the axis of the cylinder runs in the horizontal direction in the plane of the paper. The MRI system 100 includes a cryogen free superconducting magnet assembly 110 according to the first preferred embodiment of the invention. The cryogen free superconducting magnet assembly 110 includes at least one superconducting magnet 114. However, the cryogen free superconducting magnet assemblies 110 typically include a plurality of superconducting magnets 114. In a preferred embodiment of the invention, the superconducting magnets 114 are essentially completely surrounded by the thermal reservoir 112. That is, to ensure a ride though of at least 5 hours and preferably 10 hours, the superconducting magnets 114 are enclosed from all sides (including top and bottom), having only openings for leads and supports. However, the superconducting magnets 114 need not be entirely surrounded. The superconducting magnets 114 are thermally connected to the thermal reservoir 112.

To remove heat generated during use of the superconducting magnets 114, a cryocooler 120 may be thermally connected to the thermal reservoir 112. Optionally, the cyrocooler 120 may be thermally connected to the superconducting magnets 114 as well. Preferably, the thermal connection between the cryocooler 120 and the thermal reservoir 112 is made using a thermal connector 170 fabricated from a high thermal conductivity material. Typically, the thermal connector 170 is fabricated of copper. However, any material with sufficient thermal conductivity to prevent the superconducting magnets 114 from overheating may be used.

In another aspect of the invention, the thermal connection between the cryocooler 120 and the thermal reservoir 112 is made using a heat pipe. A heat pipe is an enclosed container made of a material with high conductivity and having a small amount of liquid cryogen inside. The heat pipe is configured so that cryogen pools at the end thermally connected to the thermal reservoir 112. The other end is thermally connected to the cryocooler 120. As the cryogen absorbs heat, it evaporates, carrying heat to the end thermally connected to the cryocooler 120. As heat is withdrawn, the cryogen vapor condenses and runs down the sides of the heat pipe, available to start the cycle again. If desired, the heat pipe may be used in combination with a copper rod to form a compound thermal connector 170.

The MRI system 100 according to a preferred embodiment of the invention includes one cryogen free superconducting magnet assembly 110. The cryogen free superconducting magnet assembly 110 is assembled such that an imaging volume 150 is formed therein. Also preferably included in the MRI system 100 are gradient coils 140 which allow the imaging of a specific volume of matter and passive iron shields 130 which reduce the perturbing effects of nearby magnetized objects. In one embodiment of the invention, the thermal reservoir 112 is located between the gradient coils 140 and the passive iron shield 130 within the vacuum chamber 160. Additionally, the cryogen free superconducting magnet assembly 110 is enclosed in a vacuum chamber 160. The vacuum chamber 160 isolates the thermal reservoir 112 from the rest of the MRI system 100 and the ambient, thus providing insulation.

In another preferred embodiment of the invention, the thermal reservoir 112 is located outside of the passive iron shield 130 but still within the vacuum chamber 160. That is, a particular superconducting MRI design might require that that the space between the passive iron shield 130 and the superconducting magnet 114 be relatively small, such that it is too small for an effective thermal mass for a thermal reservoir 112. Thus, in this embodiment, the thermal reservoir 112 is located beyond the passive iron shield 130 but in thermal contact with the superconducting magnets 114 via a thermal connector 170.

The thermal connector 170 may be a rod or block of a material of sufficient thermal conductivity and/or a heat pipe. Further, the thermal connector 170 may pass through the passive iron shield 130 or go around it to contact the superconducting magnets 114. In one aspect of the invention, one thermal connector 170 may be used to connect the cryocooler 120 to the thermal reservoir 112 and the superconducting magnets 114. In another aspect of the invention, separate thermal connectors 170 may used to connect the cryocooler 120 to the thermal reservoir 112 and the cryocooler 120 to the superconducting magnets 114.

In another preferred embodiment of the invention, the MRI system 100 includes two cryogen free superconducting magnet assemblies 110. In this embodiment of the invention, each cryogen free superconducting magnet assembly 110 includes superconducting magnets 114. In one aspect of this embodiment, each cryogen free superconducting magnet assembly 100 includes a respective thermal reservoir 112. In another aspect of the this embodiment, both cryogen free superconducting magnet assemblies 110 are thermally connected to a single thermal reservoir 112.

In addition to the MRI system 100 discussed above, the superconducting magnet assemblies 110 may be used in other magnetic systems. For example, additional embodiments of the invention include magnetic separators, motors and generators.

## Claims

1. A cryogen free superconducting magnet assembly (110) comprising:
a high T_{c} superconducting magnet (114); and
a thermal reservoir (112) in thermal contact with the high T_{c} superconducting magnet (114),
wherein the thermal reservoir (112) comprises a material having a heat capacity of at least about 0.065 J/gK at 25 K.

2. The assembly of claim 2, wherein the reservoir material comprises ice, epoxy, methacrylate, polyurethane, synthetic rubber, natural rubber, plastic, resin, or lead.

3. The assembly of claim 1, further comprising a cryocooler (120).

4. The assembly of claim 1, wherein the thermal reservoir (112) has a thermal capacity greater than about 9 x 10⁵ J.

5. The assembly of claim 4, wherein the thermal reservoir (112) has sufficient mass to provide ride-through of at least 10 hours.

6. A method of cooling a cryogen free superconducting magnet assembly (110) comprising:
providing a high T_{c} superconducting magnet (114) in thermal contact with a thermal reservoir (112), the thermal reservoir (112) comprising a material having a heat capacity of at least about 0.065 J/gK at 25 K;
providing a cryocooler (120) thermally connected to the high T_{c} superconducting magnet (114); and
withdrawing heat from the high T_{c} superconducting magnet (114) without using a cryogen.

7. An MRI system (100) comprising:
a cryogen free superconducting magnet assembly (110) having a high T_{c} superconducting magnet (114), and a thermal reservoir (112) in thermal contact with the high T_{c} superconducting magnet (114), the thermal reservoir (112) comprising a material having a heat capacity of at least about 0.065 J/gK at 25 K, wherein an imaging volume is formed inside the superconducting magnet (114) assembly; and
a cryocooler (120) thermally connected to the thermal reservoir (112).

8. The MRI system (100) of claim 7, wherein the thermal reservoir (112) substantially surrounds high T_{c} superconducting magnet (114).

9. An MRI system (100) comprising:
a first cryogen free superconducting magnet assembly (110) having a first high T_{c} superconducting magnet (114), and a first thermal reservoir (112) in thermal contact with the first high T_{c} superconducting magnet (114), the first thermal reservoir (112) comprising a material having a heat capacity of at least about 0.065 J/gK at 25 K; and
a second cryogen free superconducting magnet assembly (110) having a second high T_{c} superconducting magnet (114), and a second thermal reservoir (112) in thermal contact with the second high T_{c} superconducting magnet (114), the second thermal reservoir (112) comprising a material having a heat capacity of at least about 0.065 J/gK at 25 K, such that an imaging volume is formed between the first and second assemblies.

10. An MRI system (100) comprising:
a first cryogen free superconducting magnet assembly (110) having a first high T_{c} superconducting magnet (114);
a second cryogen free superconducting magnet assembly (110) having a second high T_{c} superconducting magnet (114); and
a thermal reservoir (112) in thermal contact with the first and second high T_{c} superconducting magnets (114), the thermal reservoir (112) comprising a material having a heat capacity of at least about 0.065 J/gK at 25 K,
such that an imaging volume is formed between the first and second assemblies (110).
